# EUROPEAN PATENT APPLICATION

(11) **EP 4 435 874 A1**
(43) Date of publication of application: **25.09.2024**
(21) Application number: 22924381.1
(22) Date of filing: 14.12.2022
(51) Int. Cl.: H01L 33/38, H01L 33/40, H01L 25/075, H01L 33/08, H01L 27/15

(54) **LIGHT-EMITTING DIODE**

(30) Priority: 25.01.2022 KR 20220010859; 11.03.2022 KR 20220030616
(71) Applicant: Samsung Electronics Co., Ltd., Suwon-si, Gyeonggi-do 16677 (KR)
(72) Inventor: LEE, Jinwoong, Suwon-si, Gyeonggi-do 16677 (KR); YOO, Sunghyun, Suwon-si, Gyeonggi-do 16677 (KR); JEON, Jongpil, Suwon-si, Gyeonggi-do 16677 (KR); NAMKUNG, Yong, Suwon-si, Gyeonggi-do 16677 (KR)
(74) Representative: Appleyard Lees IP LLP
(86) International application number: PCT/KR2022/020362
(87) International publication number: WO 2023/146129

(57) **Abstract**

A light-emitting diode that emits light in a red wavelength band is provided. The light-emitting diode includes a first semiconductor layer with a light-emitting surface, a second semiconductor layer, an active layer provided between the first semiconductor layer and the second semiconductor layer, a first contact electrode connected to the first semiconductor layer, a second contact electrode connected to the second semiconductor layer, and a current concentration region is located between the first connection pad and the second connection pad.

## Description

### [TECHNICAL FIELD]

The present disclosure relates to light-emitting diodes, which emit light in a red wavelength band.

### [BACKGROUND ART]

A display panel may include a substrate and a plurality of light-emitting diodes mounted on the substrate. The plurality of light-emitting diodes may be inorganic light-emitting diodes that emit light on their own.

A number of light-emitting diodes mounted on the substrate are operated in pixel or sub-pixel units to produce different colors. Each pixel or sub-pixel is controlled by a number of thin film transistors (TFTs). Each light-emitting diode emits different colors, for example, red, green, or blue.

### [DETAILED DESCRIPTION OF THE DISCLOSURE]

### [TECHNICAL SOLUTION]

The present disclosure is to provide a light-emitting diode in which left and right light amounts are substantially symmetrical by placing a current concentration region at a center of a light-emitting surface.

A light-emitting diode according to an embodiment includes a first semiconductor layer with a light-emitting surface, a second semiconductor layer, an active layer between the first semiconductor layer and the second semiconductor layer, a first contact electrode connected to the first semiconductor layer, a second contact electrode connected to the second semiconductor layer, a first connection pad connected to the first contact electrode, and a second connection pad connected to the second contact electrode, and a current concentration region of the light-emitting diode is between the first connection pad and the second connection pad.

The second contact electrode may be between the first connection pad and the second connection pad.

The second contact electrode may be connected to the second connection pad by a conductive connection member.

The second contact electrode may be disposed at a position corresponding to a center of a long side of the light-emitting diode.

The second contact electrode may be disposed at a position corresponding to a center of the light-emitting surface.

The second contact electrode may be disposed at a position corresponding to a center of the active layer.

The second contact electrode may be made of an opaque conductive material, and the conductive connection member may be made of an opaque conductive member or a transparent electrode material.

The second contact electrode may be positioned within a region of the conductive connection member.

The first contact electrode may be disposed at a position corresponding to the first connection pad, and the second contact electrode may be disposed at a position not corresponding to the second connection pad.

A first end of the second contact electrode may be connected to the second connection pad and a second end the second contact electrode extends in a direction toward the first connection pad.

The second end of the second contact electrode may be spaced apart from the first connection pad.

The second contact electrode may be made of an opaque conductive material.

The second contact electrode has in a finger-shape.

The active layer may emit light in a red wavelength band.

A size of the second contact electrode may be 1.9% to 3.2% of a size of the light-emitting surface.

### [BRIEF DESCRIPTION OF DRAWINGS]

FIG. 1 is a block diagram illustrating a display device according to an embodiment;
FIG. 2 is a plan view illustrating a light-emitting diode according to an embodiment;
FIG. 3 is a cross-sectional view along line A-A' shown in FIG. 2;
FIG. 4 is a zoomed-in view of part B shown in FIG. 3;
FIG. 5 is a schematic view illustrating an example in which a current concentration region is located in a center of a light-emitting diode according to an embodiment;
FIG. 6 is a cross-sectional view illustrating a light-emitting diode according to another embodiment;
FIG. 7 is a plan view illustrating a light-emitting diode according to another embodiment; and
FIG. 8 is a cross-sectional view along line C-C' shown in FIG. 7.

### [Detailed Description of Embodiments]

Hereinafter, example embodiments will be described in greater detail with reference to the accompanying drawings. The embodiments described herein may be modified in various ways. Specific embodiments may be depicted in the drawings and described in detail in the detailed description. However, the specific embodiments disclosed in the accompanying drawings are only intended to facilitate understanding of the various embodiments. Therefore, the technical idea is not limited to the specific embodiments disclosed in the accompanying drawings, and should be understood to include all equivalents or substitutes included in the spirit and technical scope of the disclosure.

In the disclosure, terms including ordinal numbers, such as first, second, etc., may be used to describe various components, but these components are not limited by the above-described terms. The above terms are used only for the purpose of distinguishing one component from another.

In the present disclosure, terms such as "comprise," "include," or "have" are intended to designate the presence of features, numbers, steps, operations, components, parts, or combinations thereof described in the specification, and it should be understood that the terms are not intended to exclude in advance the presence or addition of other features, numbers, steps, operations, components, parts, or combinations thereof. When it is described that a component is "connected" or "coupled" to another component, it is understood that it may be directly connected to or coupled to the other component, but that yet another component may exist in between. On the other hand, when a component is referred to as being "directly connected" or "directly coupled" to another component, it should be understood that there are no other components in between.

In the present disclosure, the expression 'same' means not only complete matching but also including a degree of difference taking into account the processing error range.

In addition, when describing the present disclosure, if it is determined that a detailed description of a related known function or configuration may unnecessarily obscure the gist of the present disclosure, the detailed description thereof is abbreviated or omitted.

In the present disclosure, a display module may include a display panel including an inorganic light-emitting diode for displaying an image. Here, the display panel may be a flat panel display panel or a curved display panel. For example, the display panel may include a plurality of inorganic light-emitting diodes (hereinafter referred to as micro-LEDs) that are about 100 micrometers (µm) or smaller to provide better contrast, response time, and energy efficiency compared to a liquid crystal display (LCD) that requires a backlight.

In the present disclosure, micro-LEDs mounted on a display panel have higher brightness, luminous efficiency, and longer lifetime than OLEDs. Micro-LEDs may be a semiconductor chip that may emit light on its own when power is supplied. Micro-LEDs have a fast response time, low power, and high brightness. For example, micro-LEDs are more efficient at converting electricity into photons compared to LCDs or OLEDs. In other words, micro-LEDs have a higher "brightness per watt" compared to LCD or OLED displays. Micro-LEDs may produce the same brightness with about half the energy compared to LEDs or OLEDs, which each exceeds about 100 µm in width, length, and height. Micro-LEDs have high resolution, superior color, contrast, and brightness, enabling them to accurately display a wide range of colors and provide a clear picture, even outdoors in bright sunlight. In addition, micro-LEDs are resistant to burn in and generate low heat, ensuring a long lifespan without deformation. Micro-LEDs may have a flip chip structure in which anode electrode and cathode electrode are formed on the same side, and the light-emitting surface is located on the opposite side of the side where the anode electrode and the cathode electrode are formed.

In the present disclosure, the display panel may include a glass substrate, a substrate of a family of synthetic resins having a flexibility material (e.g., polyimide (PI), polyethylene terephthalate (PET), polyether sulfone (PES), polyethylene naphthalate (PEN), polycarbonate (PC), and the like), or a ceramic substrate.

In the present disclosure, a substrate may have a thin film transistor (TFT) circuit formed on a front surface, and a power supply circuit for providing power to the TFT circuit and a data driving driver, a gate driving driver, and a timing controller for controlling each driving driver may be arranged on a rear surface. A plurality of pixels arranged on the front surface of the substrate may be driven by the TFT circuit.

In the present disclosure, the substrate may not have the circuit disposed on the rear surface. In this case, the TFT circuit may be manufactured in the form of a film and attached to the front surface of the substrate (in this case, the substrate may be a glass substrate).

In the present disclosure, the TFTs provided on the substrate are not limited to any particular structure or type. For example, the TFTs recited herein may be a-Si TFT (amorphous silicon) TFT, LTPS (low temperature polycrystalline silicon) TFT, LTPO (low temperature polycrystalline oxide) TFT, HOP (hybrid oxide and polycrystalline silicon) TFT, LCP (liquid crystalline polymer) TFT, OTFT (organic TFT), or graphene TFT. Alternatively, on the substrate, only a P-type (or N-type) metal oxide semiconductor field effect transistor (MOSFET) may be applied in a Si wafer complementary metal oxide silicon (CMOS) process.

In the present disclosure, a substrate may have the front surface which is divided into an active region and an inactive region. The active area may correspond to the area occupied by the TFT layer on the front surface of the substrate, and the inactive area may correspond to the area excluding the area occupied by the TFT layer on the front surface of the substrate.

In the present disclosure, a substrate may include an edge region corresponding to a periphery. The edge region of the substrate may be the remaining area of the substrate other than the area in which the circuit of the substrate is formed. Further, the edge region of the substrate may include a portion of the front surface of the substrate, which is adjacent to a side of the substrate and a portion of the rear surface of the substrate, which is adjacent to the side of the substrate. The substrate may be formed in a quadrangle type. For example, the substrate may be formed as a rectangle or a square. The edge region of the substrate may include at least one of the four sides of the substrate.

In the present disclosure, the substrate may be a substrate without a TFT layer. In this case, the substrate may include a plurality of micro integrated circuits (micro ICs) that may act as TFTs. In this case, the substrate may be formed with wirings electrically connecting the multiple micro ICs and micro-LEDs.

In the present disclosure, the pixel drive method of the display module may be an active matrix (AM) drive method or a passive matrix (PM) drive method. The display module may form a pattern of wiring to which each micro-LED is electrically connected according to the AM drive method or PM drive method.

In the present disclosure, the display module may be applied as a single unit to wearable devices, portable devices, handheld devices, and various displays installed in electronic products or electrical devices where displays are required, and may be applied to display devices such as personal computer monitors, high-definition televisions and signage (or, digital signage), electronic displays, etc. through multiple assembly arrangements in a matrix type.

Hereinafter, with reference to the accompanying drawings, embodiments of the present disclosure will be described in detail so that those skilled in the art can easily practice them. The present disclosure may be implemented in many different forms and is not limited to the embodiments described herein. In order to clearly explain the present disclosure in the drawings, parts that are not related to the description are omitted, and similar parts are given similar reference numerals throughout the specification.

Hereinafter, a display device according to various embodiments will be described with reference to the accompanying drawings.

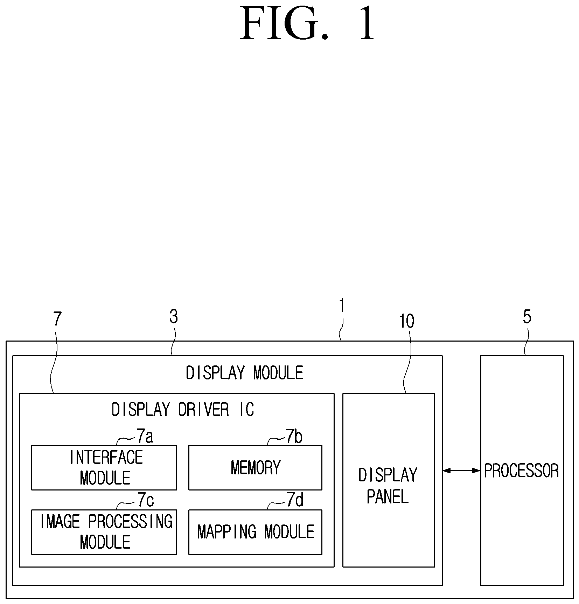

FIG. 1 is a block diagram illustrating a display device according to an embodiment.

The display device 1 of the present disclosure may include a plurality of display modules 3. In this case, the plurality of display modules 3 may be physically connected to form a large display (e.g., a large format display, LFD).

Referring to FIG. 1, the display device 1 according to an embodiment may include the display module 3 and a processor 5.

The display module 3 according to an embodiment is capable of displaying various images. Here, the images include still images and/or moving images. The display module 3 may display various images, such as broadcast content, multimedia content, and the like. In addition, the display module 3 may display a user interface and an icon.

The display module 3 may include a display panel 10 and a display driver integrated circuit (IC) 7 for controlling the display panel 10.

The display driver IC 7 may include an interface module 7a, a memory 7b (e.g., a buffer memory), an image processing module 7c, or a mapping module 7d. The display driver IC 7 may receive image information, including (for example) image data, or image control signals corresponding to commands for controlling the image data, from other components of the display device 1 through the interface module 7a. For example, according to an embodiment, the image information may be received from the processor 5, such as a main processor (e.g., an application processor) or a sub-processor (e.g., a graphics processing unit) operating independently of the functions of the main processor.

The display driver IC 7 may communicate with a sensor module (not shown) through the interface module 7a. In addition, the display driver IC 7 may store at least a portion of the received image information in the memory 7b, for example, on a frame-by-frame basis. The image processing module 7c may, for example, perform pre-processing or post-processing (e.g., resolution, brightness, or scaling) of at least a portion of the image data at least based on characteristics of the image data or characteristics of the display panel 10. The mapping module 7d may generate a voltage value or a current value corresponding to the pre-processed or post-processed image data through the image processing module 7c. According to an embodiment, the generation of the voltage value or current value may be at least partly based on properties of the pixels of the display panel 10, (e.g., the arrangement of the pixels (e.g., RGB stripe or pentile structure), or the size of each of the sub-pixels). At least some of the pixels of the display panel 10, for example, may be driven at least partly based on the voltage value or current value, such that visual information (e.g., text, images, or icons) corresponding to the image data may be displayed through the display panel 10.

The display driver IC 7 may transmit a drive signal (e.g., a driver drive signal, a gate drive signal, etc.) to the display based on the image information received from the processor 5.

The display driver IC 7 may display an image based on the image signal received from the processor 5. In one example, the display driver IC 7 may display the image by generating a drive signal of a plurality of sub-pixels based on the image signal received from the processor 5, and controlling the light emission of the plurality of sub-pixels based on the drive signal.

The display module 3 may further include a touch circuit (not shown). The touch circuit may include a touch sensor and a touch sensor IC for controlling the touch sensor. The touch sensor IC may control the touch sensor, for example, to detect a touch input or hovering input to a designated location on the display panel 10. For example, the touch sensor IC may detect a touch input or a hovering input by measuring a change in a signal (e.g., voltage, light intensity, resistance, or charge) regarding a designated location on the display panel 10. The touch sensor IC may provide information (e.g., location, area, pressure, or time) regarding the detected touch input or hovering input to the processor 5. According to an embodiment, at least a portion of the touch circuit (e.g., the touch sensor IC) may be included as part of the display driver IC 7, or as part of the display panel 10, or as part of another component (e.g., a sub-processor) disposed externally to the display module 3.

The processor 5 may be implemented by a digital signal processor (DSP) processing a digital image signal, a microprocessor, a graphics processing unit (GPU), an artificial intelligence (AI) processor, a neural processing unit (NPU), or a time controller (TCON). However, the processor 5 is not limited thereto, and may include one or more of a central processing unit (CPU), a micro controller unit (MCU), a micro processing unit (MPU), a controller, an application processor (AP), a communication processor (CP), and an ARM processor, or may be defined by these terms. In addition, the processor 5 may be implemented by a system-on-chip (SoC) or a large scale integration (LSI) in which a processing algorithm is embedded or may be implemented in the form of an application specific integrated circuit (ASIC) or a field programmable gate array (FPGA).

The processor 5 may control hardware or software components connected to the processor 5 by running an operating system or application program, and may perform various data processing and calculations. In addition, the processor 5 may load and process commands or data received from at least one of the other components into a volatile memory and store various data in a non-volatile memory.

The display panel 10 may include a substrate and a plurality of pixels. The substrate may include pixel regions in which a plurality of pixels are arranged. Each pixel region may have one pixel disposed therein. A pixel may include a plurality of subpixels. For example, the plurality of subpixels may include a first light-emitting diode emitting light in a red wavelength band, a second light-emitting diode emitting light in a green wavelength band, and a third light-emitting diode emitting light in a blue wavelength band. The first, second, and third light-emitting diodes may be, for example, inorganic light-emitting devices, such as micro-LEDs (light-emitting diodes) having a size of about 100 micrometers (µm) or less. In this case, the first, second, and third light-emitting diodes may be a flip chip type in which an anode connection pad and a cathode connection pad are disposed together on opposite sides of the light-emitting surface.

A plurality of thin film transistors (TFTs) for driving the first, second, and third micro light-emitting diodes may be disposed in a portion of the pixel area not occupied by the first to third micro light-emitting diodes.

The first and third light-emitting diodes may be arranged in a row at regular intervals within a single pixel area, but are not limited thereto. For example, the first and third light-emitting diodes may be arranged in an L-shape or in a pentile RGBG method. The pentile RGBG method utilizes the fact that humans are less able to discriminate blue and most able to discriminate green, and arranges the number of red, green, and blue subpixels in a ratio of 1:1:2 (RGBG). The pentile RGBG method is effective because it increases yields, lowers unit costs, and enables high resolution on a small screen.

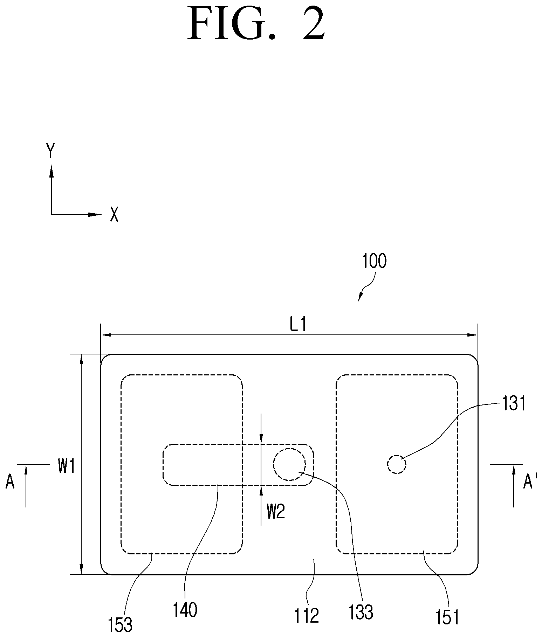

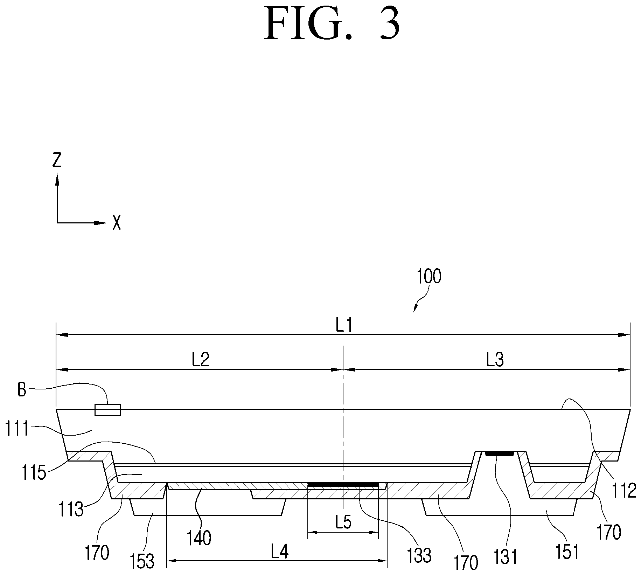

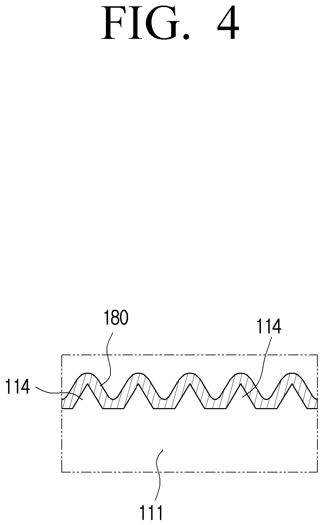

FIG. 2 is a plan view illustrating a light-emitting diode according to an embodiment, FIG. 3 is a cross-sectional view along line A-A' shown in FIG. 2, and FIG. 4 is a zoomed-in view of part B shown in FIG. 3.

Referring to FIGS. 2 and 3, the light-emitting diode 100 according to an embodiment may be a red light-emitting diode that emits light in the red wavelength band.

The light-emitting diode 100 according to an embodiment may include a first semiconductor layer 111, a second semiconductor layer 113, and an active layer 115 provided between the first semiconductor layer 111 and the second semiconductor layer 113.

The first semiconductor layer 111, the active layer 115, and the second semiconductor layer 113 may be formed using methods such as metal organic chemical vapor deposition (MOCVD), chemical vapor deposition (CVD), or plasma-enhanced chemical vapor deposition (PECVD).

The first semiconductor layer 111 may include, for example, a p-type semiconductor layer (anode). The p-type semiconductor layer may be selected from, for example, GaAs, GaP, GaAlAs, or InGaAlP.

The active layer 115 is a region where electrons and holes recombine, and as the electrons and holes recombine, they transition to lower energy levels and may generate light with corresponding wavelengths.

The active layer 115 may include a semiconductor material, such as amorphous silicon or poly crystalline silicon. Alternatively, the active layer 115 may include an organic semiconductor material, and may be formed in a single quantum well (SQW) structure or a multi-quantum well (MQW) structure.

The second semiconductor layer 113 may include, for example, an n-type semiconductor layer (cathode). The n-type semiconductor layer may be selected from, for example, GaAs, GaP, GaAlAs, or InGaAlP.

The light-emitting diode 100 according to an embodiment may have a hole type mesa structure. In this case, a first connection pad 151 may be connected to the first semiconductor layer 111 through holes penetrating the second semiconductor layer 113 and the active layer 115.

In addition, when a hole-type mesa structure is applied to the light-emitting diode 100, a portion of the active layer 115 may be exposed to the outside. The exposed portion of the active layer 115 may be protected by a passivation layer 170.

In addition to preventing the active layer 115 from being exposed to the outside, the passivation layer 170 may protect the exterior of the light-emitting diode 100 from external environments such as moisture and oxygen.

The passivation layer 170 may cover one side of the light-emitting diode 100 (e.g., a side opposite to a light-emitting surface 112 of the light-emitting diode 100) on which the first connection pad 151 and the second connection pad 153 are disposed, and an edge portion of the active layer 115.

The passivation layer 170 may also cover the sides of the first semiconductor layer 111, although not shown in the corresponding drawing.

A first contact electrode 131 is provided for ohmic contacts between the first semiconductor layer 111 and the first connection pad 151, and may be made of an opaque metal (e.g., Al, Pt, Au, Cu, or Cr).

A portion of the first contact electrode 131 may be in contact with the first semiconductor layer 111, and another portion may be disposed on the passivation layer 170 covering the second semiconductor layer 113.

A second contact electrode 133 may be electrically connected to a second connection pad 153 through a conductive connection member 140. The second contact electrode 133 may be made of an opaque metal (e.g., Al, Pt, Au, Cu, or Cr).

The area of the second contact electrode 133 may have an optimal area proportional to the area of the light-emitting surface 112 (or the area of the active layer 115) of the light-emitting diode 100. In this case, if the area of the second contact electrode 133 is smaller than the optimal area, the operating voltage VF may increase due to a decrease in current injection efficiency, and if the area is larger than the optimal area, the current concentration effect may deteriorate (sidewall leakage), resulting in a decrease in light efficiency.

For example, when the TFT provided in the display panel 10 of the present disclosure is driven by a pulse width modulation (PWM) drive method with low current drive of 150µA or less, the optimal area range of the second contact electrode 133 may be from 1.9% to 3.2% of the area of the light-emitting surface 112 of the light-emitting diode 100 to secure optimal efficiency characteristics.

The second contact electrode 133 may be disposed at a location spaced apart from the second connection pad 153. For example, the second contact electrode 133 may be positioned between the first connection pad 151 and the second connection pad 153.

The light-emitting surface 112 of the light-emitting diode 100 may be a rectangle having a length L1 and a width W1 as shown in FIG. 2. In this case, the length L1 may be larger than the width W1.

The second contact electrode 133 may be provided on the second semiconductor layer 113 at a position corresponding to approximately the center of the light-emitting surface 112 of the light-emitting diode 100.

For example, the center of the second contact electrode 133 may be positioned at a location corresponding to a predetermined length L2 from one side of the light-emitting diode 100. Alternatively, the center of the second contact electrode 133 may be positioned at a location corresponding to a predetermined length L3 from the other side of the light-emitting diode 100. In this case, the lengths L2 and L3 may be substantially the same.

In the second contact electrode 133, a center-to-left length of the second contact electrode 133 may be the same as a center-to-right length of the second contact electrode 133. Alternatively, the second contact electrode 133 may be formed such that the left portion and the right portion are symmetrical with reference to the center of the second contact electrode 133.

The second contact electrode 133 disposed in the center of the light-emitting diode 100, may be electrically connected to the second connection pad 153 through the conductive connection member 140. In this case, the second contact electrode 133 may be disposed on an inner side of the conductive connection member 140 such that it does not leave the conductive connection member 140.

The conductive connection member 140 may be rectangular with a large ratio of long to short sides. For example, the length ratio of the long side to the short side of the conductive connection member 140 may be about 4:1 to 6:1, but is not limited thereto.

The length L4 of the conductive connection member 140 may be larger than the length L5 of the second contact electrode 133. In this case, if the second contact electrode 133 is circular, the length L5 may be the diameter of the second contact electrode 133.

The area of the conductive connection member 140 may be smaller than the area of the second connection pad 153. For example, when the length L1 of the light-emitting surface 112 of the light-emitting diode 100 is about 58 µm, the width W1 of the light-emitting surface 112 of the light-emitting diode 100 is about 34 µm, and the length L5 of the second contact electrode 133 is about 7 µm to 9 µm, the length L4 of the conductive connection member 140 may be about 10 µm to 25 µm, and the width W2 of the conductive connection member 140 may be about 9 µm to 11 µm.

The optimal size L4×W2 of the conductive connection member 140 may be determined by considering the size L1×W1 of the light-emitting surface 112 of the light-emitting diode 100 and the length or diameter of the second contact electrode 133 together.

The outer periphery of the second contact electrode 133 disposed on one side of the conductive connection member 140 may be spaced from the outer periphery of the conductive connection member 140 to the inner side of the conductive connection member 140 at a distance of about 1 µm, but is not limited thereto.

The conductive connection member 140 does not need be limited to a particular length (e.g., L1), width (e.g., W2), or shape, and may have a variety of shapes and sizes such that the second contact electrode 133 is positioned at a location corresponding to the center of the light-emitting surface 112 of the light-emitting diode 100.

The conductive connection member 140 may be made of a material that has metallic conductive properties and low ohmic properties of the second semiconductor layer 113. For example, the conductive connection member 140 may be made of a transparent electrode material (e.g., ITO or ZnO) or an opaque electrode material (e.g., Al, Pt, Au, Cu, or Cr).

The first connection pad 151 and the second connection pad 153 may be spaced apart and disposed on opposite sides of the light-emitting surface 112 of the light-emitting diode 100.

The first connection pad 151 may be disposed on the second semiconductor layer 113 for electrical connection between the first semiconductor layer 111 and a connection pad (not shown) on the substrate. In this case, the first connection pad 151 may be electrically connected to the first semiconductor layer 111 through the first contact electrode 131.

The second connection pad 153 may be disposed on the second semiconductor layer 113 for electrical connection between the second semiconductor layer 113 and a connection pad (not shown) on the substrate. In this case, the second connection pad 153 may be physically and electrically connected to the second contact electrode 133.

The first connection pad 151 and the second connection pad 153 may be made of, but are not limited to, Au or an alloy containing Au.

The passivation layer 170 may include an inorganic insulating film (e.g., silicon oxide (SiO2 )) and/or an organic insulating film (e.g., general purpose polymer (PMMA or PS)). As such, the passivation layer 170 may have a composite laminated structure of an inorganic and an organic insulating film.

Referring to FIG. 4, the light-emitting diode 100 according to an embodiment may have an uneven part 114 formed in a curved pattern at regular or irregular intervals on the light emitting surface 112 provided in the first semiconductor layer 111. The light-emitting diode 100 according to an embodiment may have a light-emitting area that is maximized by the uneven part 114 of the light-emitting surface 112, and the critical angle of light emission may increase, thereby improving the light-emitting efficiency.

In this case, the light-emitting diode 100 according to an embodiment may have a passivation layer 180 covering the uneven part 114 to protect the light-emitting surface 112.

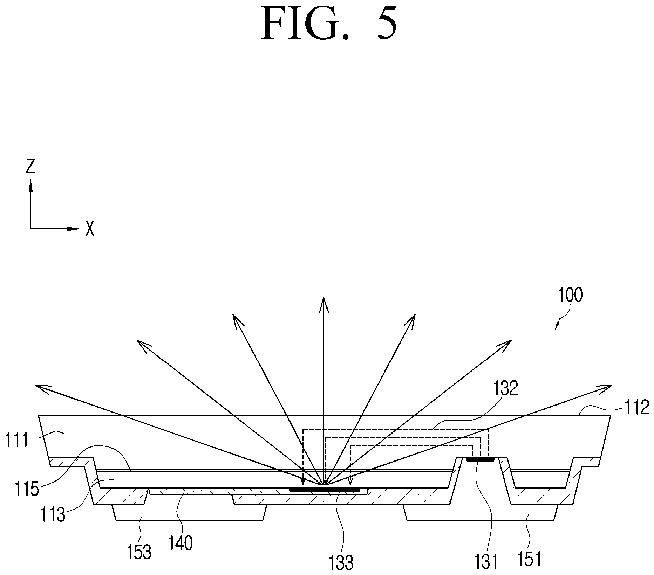

FIG. 5 is a schematic view illustrating an example in which a current concentration region is located in a center of a light-emitting diode according to an embodiment.

Referring to FIG. 5, the light-emitting diode 100 may emit light in the red wavelength band from the active layer 115 when current 132 flows from the first connection pad 151 to the second connection pad 153.

The second contact electrode 133 is configured such that a portion of the active layer 115 corresponding to the second contact electrode 133 may be the light emission concentration area.

The light emission concentration area in the active layer 115 may be a location corresponding to the location of the second contact electrode 133. Accordingly, since the second contact electrode 133 is at a position corresponding to the center of the light-emitting surface 112 of the light-emitting diode 100, the light emission concentration area in the active layer 115 may be at a position corresponding to the center of the light-emitting surface 112 of the light-emitting diode 100.

As such, the light emission concentration area may be positioned in the center of the light-emitting surface 112 of the light-emitting diode 100. Accordingly, the light emission concentration area may not be offset to the left or right of the light-emitting surface 112 of the light-emitting diode 100, so that the left and right light amounts emitted to the left and right of the light-emitting surface 112 of the light-emitting diode 100 may be substantially symmetrical, as shown in FIG. 5.

Thus, the light-emitting diode 100 according to an embodiment may improve the left-to-right full white color deviation when viewed from the same angle (or similar angles) on the left and right sides of the light-emitting surface 112. In other words, the light-emitting diode 100 may improve the white balance by improving the luminance deviation according to the user's viewing direction (e.g., the direction in which the user is looking at the display device 1 from the front, left, and right sides of the display device 1).

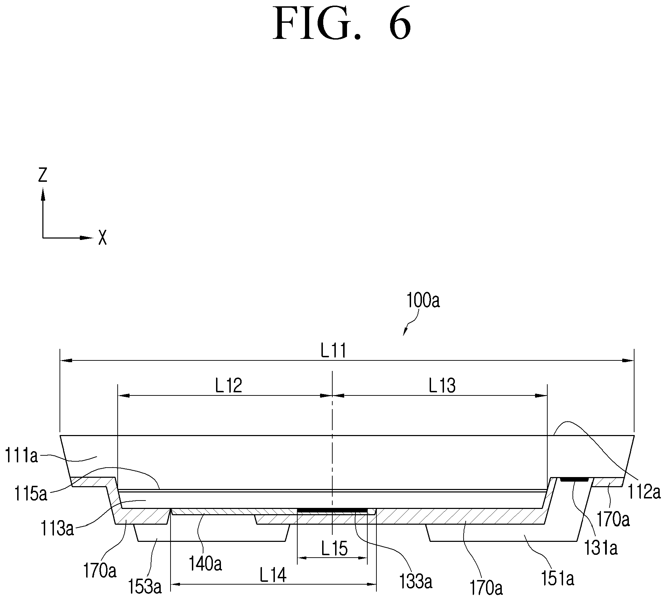

FIG. 6 is a cross-sectional view illustrating a light-emitting diode according to another embodiment.

The light-emitting diode 100a according to another embodiment is substantially identical in most configurations to the configuration of the light-emitting diode 100 described above and differs in some configurations. Accordingly, hereinafter, in describing the light-emitting diode 100a, configurations that are identical to the light-emitting diode 100 described above will be omitted from the description and the description will focus on configurations that differ from the light-emitting diode 100 described above.

Referring to FIG. 6, the light-emitting diode 100a according to another embodiment may have an edge type mesa structure. In this case, the first connection pad 151a may extend along a side of the second semiconductor layer 113a and the active layer 115a. The first connection pad 151a may be electrically connected to the first semiconductor layer 111a through the first contact electrode 131a.

The second contact electrode 133a may be positioned on the second semiconductor layer 113a corresponding to approximately the center of the active layer 115a.

For example, the center of the second contact electrode 133a may be positioned at a location corresponding to a predetermined length L12 from one side of the active layer 115a. Alternatively, the center of the second contact electrode 133a may be positioned at a location corresponding to a predetermined length L13 from the other side of the active layer 115a. In this case, lengths L12 and L13 may be substantially the same.

In this case, the center of the active layer 115a may coincide with the center of the light-emitting surface 112a of the light-emitting diode 100a. Alternatively, the center of the active layer 115a may be shifted by a predetermined distance to the left or right from the center of the light-emitting surface 112a of the light-emitting diode 100a. As described above, the center of the second contact electrode 133a may be positioned at a location corresponding to the center of the active layer 115a. Accordingly, the center of the second contact electrode 133a may correspond to the center of the light-emitting surface 112a of the light-emitting diode 100a, or may correspond to a point slightly offset to the left or right from the center of the light-emitting surface 112a.

Since the current is concentrated on the second contact electrode 133a, the current concentration region of the light-emitting diode 100a may be a point corresponding approximately to the center of the light-emitting surface 112a of the light-emitting diode 100a. Accordingly, since the light emission concentration area of the light-emitting diode 100a is not offset to the left or right of the light-emitting surface 112a of the light-emitting diode 100a, the left and right light amounts emitted from the light-emitting surface 112a of the light-emitting diode 100a may be approximately symmetrical.

Accordingly, the light-emitting diode 100a according to another embodiment, like the light-emitting diode 100 described above, may improve the left-to-right full white color deviation when viewed from the same angle (or similar angles) on the left and right sides of the light-emitting surface 112a, thereby improving the left-to-right white balance of the display device 1.

In FIG. 6, among the reference numerals not described, 140a refers to the conductive connection member, 151a refers to the first connection pad, 153a refers to the second connection pad, 170a refers to the passivation layer, L11 refers to a length of the light-emitting surface 112a, L14 refers to a length of the conductive connection member 140a, and L15 refers to a length of the second contact electrode 133a.

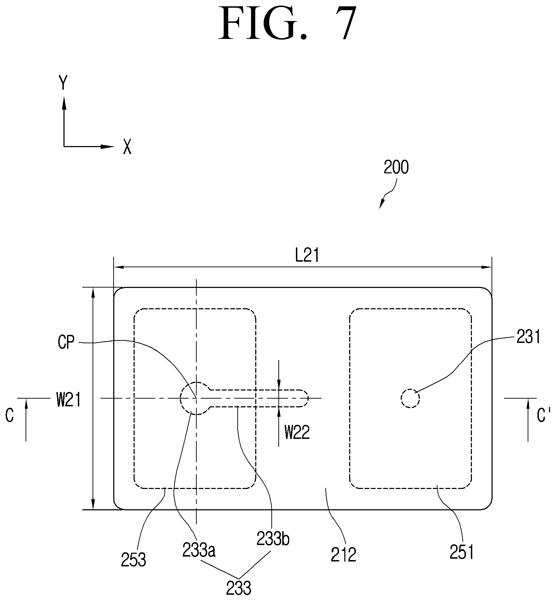

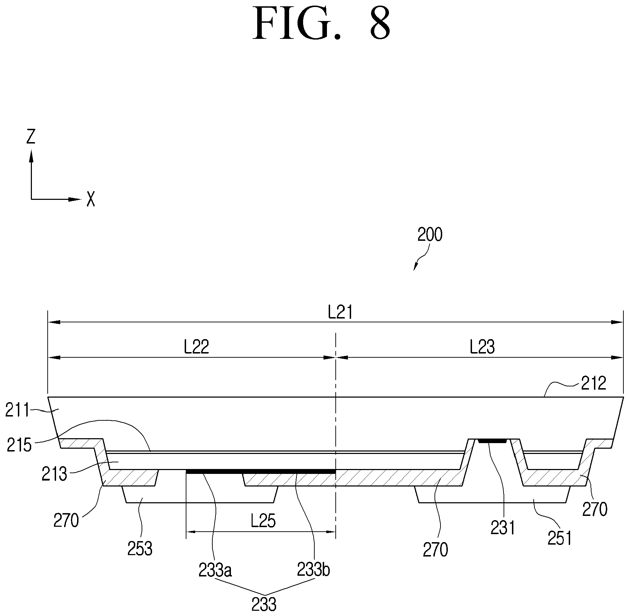

FIG. 7 is a plan view illustrating a light-emitting diode according to another embodiment, and FIG. 8 is a cross-sectional view along line C-C' shown in FIG. 7.

The light-emitting diode 200 according to another embodiment is substantially identical in most configurations to the configuration of the light-emitting diode 100 described above and differs in some configurations. Accordingly, hereinafter, in describing the light-emitting diode 200, configurations that are identical to the light-emitting diode 100 described above will be omitted from the description and the description will focus on configurations that differ from the light-emitting diode 100 described above.

Referring to FIGS. 7 and 8, a light-emitting diode 200 may include a second contact electrode 233 having a first portion 233a and a second portion 233b formed integrally.

The second contact electrode 233 may be approximately finger-shaped. For example, the first portion 233a of the second contact electrode 233 may be connected to a second connection pad 253. The second portion 233b of the second contact electrode 233 may extend from the first portion 233a along the second connection pad 253 and may be formed to extend beyond the perimeter of the second connection pad 253.

The first portion 233a of the second contact electrode 233 may be provided at a position corresponding to approximately the center of the second connection pad 253.

The leading edge of the second portion 233b of the second contact electrode 233 may correspond to the center of the light-emitting surface 212 of the light-emitting diode 200 or may be positioned at a point adjacent to the center of the light-emitting surface 212 of the light-emitting diode 200.

The leading edge of the second portion 233b of the second contact electrode 233 may be positioned at a point corresponding to the predetermined length L22 from the left side of the light-emitting diode 200 toward the center of the light-emitting diode 200. Alternatively, the leading edge of the second portion 233b of the second contact electrode 233 may be positioned at a point corresponding to a predetermined length L23 from the right side of the light-emitting diode 200 toward the center of the light-emitting diode 200. L22 and L23 may be substantially the same length.

The width W22 of the second portion 223b of the second contact electrode 233 may be about 1 µm to 4 µm. If the width W22 of the second portion 223b of the second contact electrode 233 is less than 1 µm, the disconnection defect rate may increase, and if it exceeds 4 µm, the degree to which the current concentration region is offset from the center of the light-emitting surface 212 of the light-emitting diode 200 may increase.

The width W22 of the second portion 223b of the second contact electrode 233 may also be limited to an appropriate range proportional to the size of the light-emitting surface 212 of the light-emitting diode 200.

In FIG. 7, among the reference numerals not described, L21 refers to a length of the light-emitting surface 212 and W21 refers to a width of the light-emitting surface 212. In FIG. 8, 211 refers to a first semiconductor layer, 213 refers to a second semiconductor layer, 215 refers to an active layer, 231 refers to a first contact electrode, 251 refers to a first connection pad, and 270 refers to a passivation layer.

As described above, according to various embodiments of the present disclosure, it is possible to minimize or improve the light emission concentration area being offset to the left or right of the light-emitting surface of the light-emitting diode by positioning the light emission concentration area in the center of the light-emitting surface of the light-emitting diode. Accordingly, by symmetrically aligning the left and right light amounts of the light-emitting surface of the light-emitting diode, white balance can be improved by minimizing luminance deviation according to the user's viewing direction.

While preferred embodiments of the present disclosure have been shown and described above, the disclosure is not limited to the specific embodiments described above, and various modifications may be made by one of ordinary skill in the art without departing from the gist of the disclosure as claimed in the claims, and such modifications should not be understood in isolation from the technical ideas or views of the disclosure.

## Claims

1. A light-emitting diode comprising:
a first semiconductor layer comprising a light-emitting surface;
a second semiconductor layer;
an active layer between the first semiconductor layer and the second semiconductor layer;
a first contact electrode connected to the first semiconductor layer;
a second contact electrode connected to the second semiconductor layer;
a first connection pad connected to the first contact electrode; and
a second connection pad connected to the second contact electrode,
wherein a current concentration region of the light-emitting diode is between the first connection pad and the second connection pad.

2. The light-emitting diode as claimed in claim 1, wherein the second contact electrode is between the first connection pad and the second connection pad.

3. The light-emitting diode as claimed in claim 2, wherein the second contact electrode is connected to the second connection pad by a conductive connection member.

4. The light-emitting diode as claimed in claim 3, wherein the second contact electrode is disposed at a position corresponding to a center of a long side of the light-emitting diode.

5. The light-emitting diode as claimed in claim 3, wherein the second contact electrode is disposed at a position corresponding to a center of the light-emitting surface.

6. The light-emitting diode as claimed in claim 3, wherein the second contact electrode is disposed at a position corresponding to a center of the active layer.

7. The light-emitting diode as claimed in claim 3, wherein the second contact electrode comprises an opaque conductive material, and
wherein the conductive connection member comprises an opaque conductive member or a transparent electrode material.

8. The light-emitting diode as claimed in claim 3, wherein the second contact electrode is located within a region of the conductive connection member.

9. The light-emitting diode as claimed in claim 1, wherein the first contact electrode is disposed at a position corresponding to the first connection pad; and
wherein the second contact electrode is disposed at a position not corresponding to the second connection pad.

10. The light-emitting diode as claimed in claim 1, wherein a first end of the second contact electrode is connected to the second connection pad and a second end of the second contact electrode extends in a direction toward the first connection pad.

11. The light-emitting diode as claimed in claim 10, wherein the second end of the second contact electrode is spaced apart from the first connection pad.

12. The light-emitting diode as claimed in claim 10, wherein the second contact electrode comprises an opaque conductive material.

13. The light-emitting diode as claimed in claim 10, wherein the second contact electrode has a finger-shape.

14. The light-emitting diode as claimed in claim 1, wherein the active layer is configured to emit light in a red wavelength band.

15. The light-emitting diode as claimed in claim 1, wherein a size of the second contact electrode is 1.9% to 3.2% of a size of the light-emitting surface.
